# EUROPEAN PATENT APPLICATION

(11) **EP 4 586 327 A1**
(43) Date of publication of application: **16.07.2025**
(21) Application number: 24750513.4
(22) Date of filing: 29.01.2024
(51) Int. Cl.: H01L 33/62, H01L 33/26, H01L 33/38, H01L 33/48, H01L 23/00, H01L 27/15, H01L 33/00, H01L 25/075

(54) **MICRO-LED CHIP AND MANUFACTURING METHOD THEREFOR**

(30) Priority: 30.01.2023 KR 20230011738
(71) Applicant: Samsung Electronics Co., Ltd., Suwon-si, Gyeonggi-do 16677 (KR)
(72) Inventor: MIN, Sungyong, Suwon-si Gyeonggi-do 16677 (KR); LEE, Changjoon, Suwon-si Gyeonggi-do 16677 (KR); JANG, Kyungwoon, Suwon-si Gyeonggi-do 16677 (KR)
(74) Representative: Appleyard Lees IP LLP
(86) International application number: PCT/KR2024/001333
(87) International publication number: WO 2024/162712

(57) **Abstract**

A micro light emitting diode (LED) chip includes: a first semiconductor layer doped with an N-type dopant; a second semiconductor layer provided at a lower surface of the first semiconductor layer, and doped with a P-type dopant; an active layer provided between the first semiconductor layer and the second semiconductor layer, and configured to emit light; and an electrode pad provided at a lower surface of the second semiconductor layer, wherein the electrode pad may include a groove structure having a depth that increases from an edge of the electrode pad towards a center of the electrode pad.

## Description

### [TECHNICAL Field]

The disclosure relates to a micro light emitting diode (LED) chip and a method for manufacturing thereof, and more particularly, to a micro LED chip with an electrode pad structure for preventing a faulty connection from occurring Conductive balls included in an anisotropic conductive film may be forced into an outer region between electrodes on an electrode pad and a panel substrate due to pressure from a process of thermally compressing an electrode pad of the micro LED chip on the panel substrate, and a method for manufacturing thereof.

### [BACKGROUND ART]

An LED may be formed in a P-N junction structure of an N-type semiconductor and a P-type semiconductor, and a photon corresponding to a band gap is emitted as an electron injected from an electrode to a semiconductor and a hole recombine over the band gap in the P-N junction part and thereby, observed as light to a naked eye of a person.

A micro LED display may be formed of an inorganic emissive material and refers to a display made of micro LEDs with horizontal and vertical lengths being less than 100 µm, respectively. A micro LED chip may be configured such that a length thereof compared to an LED chip of the related art is about one-tenth, and an area is about one-hundredth.

The micro LED may have an advantage from an efficiency and longevity aspect in that, unlike an organic light emitting diode (OLED) which uses organic materials, there is no burn-in phenomenon of a display device being degraded as no organic materials are used.

The micro LED chip may be manufactured through a thermal-compression process after being disposed on a display panel substrate laminated with an anisotropic conductive film including conductive balls at a surface thereof.

Based on the method described above, the micro LED chip may implement a display screen by an LED which emits a red light, a green light, and a blue light being disposed on a display panel substrate in a RGB pixel basis and generating and irradiating light toward a front direction thereof.

### [Disclosure]

### [Technical Solution]

According to an aspect of the disclosure, a micro light emitting diode (LED) chip includes: a first semiconductor layer doped with an N-type dopant; a second semiconductor layer provided at a lower surface of the first semiconductor layer, and doped with a P-type dopant; an active layer provided between the first semiconductor layer and the second semiconductor layer, and configured to emit light; and an electrode pad provided at a lower surface of the second semiconductor layer, wherein the electrode pad may include a groove structure having a depth that increases from an edge of the electrode pad towards a center of the electrode pad.

The groove structure of the electrode pad may have a cross-section in a diagonal form connecting the edge of the electrode pad and the center of the electrode pad.

The groove structure of the electrode pad may have a cross-section in a stair form.

The groove structure of the electrode pad may have a cross-section in an arch form.

The electrode pad may include a first electrode pad provided at a first region of the lower surface of the second semiconductor layer and a second electrode pad provided at a second region of the second semiconductor layer and spaced apart from the first electrode pad by a distance that is less than or equal to 20 µm.

According to an aspect of the disclosure, a micro light emitting diode (LED) panel includes: a first semiconductor layer doped with an N-type dopant; a second semiconductor layer provided at a lower surface of the first semiconductor layer, and doped with a P-type dopant; an active layer provided between the first semiconductor layer and the second semiconductor layer, and configured to emit light; an electrode pad provided at a lower surface of the second semiconductor layer; and a substrate provided at a lower surface of the electrode pad, wherein the electrode pad includes: a groove structure that having a depth that increases from an edge of the electrode pad towards a center of the electrode pad, and conductive balls provided in the groove structure of the electrode pad between the electrode pad and the substrate.

According to an aspect of the disclosure, a method for manufacturing a micro light emitting diode (LED) chip, includes: sequentially forming a first semiconductor layer doped with an N-type dopant, an active layer configured to emit light, and a second semiconductor layer doped with a P-type dopant on a growth substrate; forming a pixel device electrically spaced apart by etching the first semiconductor layer, the active layer, and the second semiconductor layer; and forming an electrode pad over the pixel device, wherein the electrode pad may include a groove structure having a depth that increases from an edge of the electrode pad towards a center of the electrode pad.

The forming the electrode pad may include forming the groove structure by mechanical molding processing a lower surface of the electrode pad.

The forming the electrode pad may include forming the groove structure by plasma processing a lower surface of the electrode pad.

The forming the electrode pad may include forming the groove structure by etching a lower surface of the electrode pad.

The forming the electrode pad may include forming the electrode pad to have a cross-section in at least one of a diagonal form connecting the edge of the electrode pad and the center of the electrode pad, a cross-section in a stair form, or a cross-section in an arch-form.

The forming the electrode pad may include: forming a first electrode pad provided at a first region of a lower surface of the second semiconductor layer and a second electrode pad provided at a second region of the second semiconductor layer and spaced apart from the first electrode pad by a distance that is less than or equal to 20 µm.

According to an aspect of the disclosure, a method for manufacturing a micro light emitting diode (LED) panel, includes: providing an anisotropic conductive film on a panel substrate; forming a micro LED chip including an electrode pad including a groove structure that may have a depth that increases an edge of the electrode pad towards a center of the electrode pad; transferring the micro LED chip onto the laminated panel substrate; and thermally compressing the panel substrate onto which the micro LED chip is transferred.

The forming the micro LED chip may include: sequentially forming a first semiconductor layer doped with an N-type dopant, an active layer configured to emit light, and a second semiconductor layer doped with a P-type dopant on a growth substrate; forming a pixel device electrically spaced apart by etching the first semiconductor layer, the active layer, and the second semiconductor layer; and forming the electrode pad over the formed pixel device.

The forming the micro LED chip may include forming a first electrode pad provided at a first region of a lower surface of a second semiconductor layer and a second electrode pad provided at a second region of the second semiconductor layer and spaced apart from the first electrode pad by a distance that is less than or equal to 20 µm.

According to an aspect of the disclosure, a micro light emitting diode (LED) includes: a first semiconductor layer; a second semiconductor layer provided at a lower surface of the first semiconductor layer; an active layer provided between the first semiconductor layer and the second semiconductor layer; and an electrode pad provided on a lower surface of the second semiconductor layer, wherein the electrode pad may include a groove having depth that increases from an edge of the electrode pad towards a center of the electrode pad.

The groove of the electrode pad may have a cross-section in a diagonal form connecting the edge of the electrode pad and the center of the electrode pad.

The groove of the electrode pad may have a cross-section in a stair form.

The groove of the electrode pad may have a cross-section in an arch form.

The electrode pad may include a first electrode pad provided at a first region of the lower surface of the second semiconductor layer and a second electrode pad provided at a second region of the second semiconductor layer and spaced apart from the first electrode pad by a distance that is less than or equal to 20 µm.

### [Description of Drawings]

The above and other aspects, features, and advantages of certain embodiments of the present disclosure will be more apparent from the following description taken in conjunction with the accompanying drawings, in which:
FIG. 1 is a cross-sectional view illustrating a structure of a micro LED chip, according to an embodiment of the disclosure;
FIG. 2A is a cross-sectional view illustrating a structure of a micro LED panel to which a micro LED chip is disposed at an upper surface thereof, according to an embodiment of the disclosure;
FIG. 2B is a plan view illustrating electrodes, conductive balls, and an anisotropic conductive film (ACF) disposed at an upper surface of a micro LED panel substrate and a structure of a micro LED chip disposed at an upper surface of the anisotropic conductive film, according to an embodiment of the disclosure;
FIG. 3 is a cross-sectional view illustrating a process of thermally compressing a micro LED chip to an upper surface of a micro LED panel substrate, according to an embodiment of the disclosure;
FIG. 4A is a plan view illustrating an example in which a groove structure of an electrode pad of a micro LED chip is a cross section in a diagonal form connecting an edge of the electrode pad and a center part of the electrode pad, according to an embodiment of the disclosure;
FIG. 4B is a cross-sectional view illustrating an example in which a groove structure of an electrode pad of a micro LED chip is a cross section in a diagonal form connecting an edge of the electrode pad and a center part of the electrode pad, according to an embodiment of the disclosure;
FIG. 5A is a plan view illustrating an example in which a groove structure of an electrode pad of a micro LED chip is a cross section in a stair form, according to an embodiment of the disclosure;
FIG. 5B is a cross-sectional view illustrating an example in which a groove structure of an electrode pad of a micro LED chip is a cross-section in a stair form, according to an embodiment of the disclosure;
FIG. 6A is a plan view illustrating an example in which a groove structure of an electrode pad of a micro LED chip is a cross-section in an arch form, according to an embodiment of the disclosure;
FIG. 6B is a cross-sectional view illustrating an example in which a groove structure of an electrode pad of a micro LED chip is a cross-section in an arch form, according to an embodiment of the disclosure;
FIG. 7 is a cross-sectional view illustrating a flow of conductive balls attributed to a groove structure of an electrode pad of a micro LED chip, according to an embodiment of the disclosure;
FIG. 8 is a flowchart illustrating a process of manufacturing a micro LED chip, according to an embodiment of the disclosure;
FIG. 9 is a flowchart illustrating a process of manufacturing a micro LED panel, according to an embodiment of the disclosure; and
FIG. 10 is a cross-sectional view illustrating a process of manufacturing a micro LED panel, according to an embodiment of the disclosure.

### [Detailed Description of Exemplary Embodiments]

Various modifications may be made to the embodiments of the disclosure, and there may be various types of embodiments. Accordingly, specific embodiments will be illustrated in drawings, and the embodiments will be described in detail in the detailed description. However, it should be noted that the various embodiments are not for limiting the scope of the disclosure to a specific embodiment, but they should be interpreted to include all modifications, equivalents or alternatives of the embodiments included in the ideas and the technical scopes disclosed herein. With respect to the description of the drawings, like reference numerals may be used to indicate like elements.

In describing the disclosure, in case it is determined that the detailed description of related known technologies may unnecessarily confuse the gist of the disclosure, the detailed description thereof will be omitted.

Further, the embodiments below may be modified to various different forms, and it is to be understood that the scope of the technical spirit of the disclosure is not limited to the embodiments below. Rather, the embodiments are provided so that the disclosure will be thorough and complete, and to fully convey the technical spirit of the disclosure to those skilled in the art.

Terms used in the disclosure have been merely used to described a specific embodiment, and is not intended to limit the scope of protection. A singular expression includes a plural expression, unless otherwise specified.

In the disclosure, expressions such as "have," "may have," "include," "may include," or the like are used to designate a presence of a corresponding characteristic (e.g., elements such as numerical value, function, operation, or component), and not to preclude a presence or a possibility of additional characteristics.

In the disclosure, expressions such as "A or B," "at least one of A and/or B," or "one or more of A and/or B" may include all possible combinations of the items listed together. For example, "A or B," "at least one of A and B," or "at least one of A or B" may refer to all cases including (1) only A, (2) only B, or (3) both of A and B.

Expressions such as "first," "second," "1st," "2nd," and so on used herein may be used to refer to various elements regardless of order and/or importance, and it should be noted that the expressions are merely used to distinguish an element from another element and not to limit the relevant elements.

When a certain element (e.g., first element) is indicated as being "(operatively or communicatively) coupled with/to" or "connected to" another element (e.g., second element), it may be understood as the certain element being directly coupled with/to the another element or as being coupled through other element (e.g., third element).

On the other hand, when a certain element (e.g., first element) is indicated as "directly coupled with/to" or "directly connected to" another element (e.g., second element), it may be understood as the other element (e.g., third element) not being present between the certain element and the another element.

The expression "configured to... (or set up to)" used in the disclosure may be used interchangeably with, for example, "suitable for...," "having the capacity to...," "designed to...," "adapted to...," "made to...," or "capable of..." based on circumstance. The term "configured to... (or set up to)" may not necessarily mean "specifically designed to" in terms of hardware.

The expression "a device configured to..." may mean something that the device "may perform..." together with another device or components.

The term "module" or "part" used in an embodiment herein perform at least one function or operation, and may be implemented with a hardware or software, or implemented with a combination of hardware and software. In addition, a plurality of "modules" or a plurality of "parts," except for a "module" or a "part" which needs to be implemented to a specific hardware, may be integrated to at least one module and implemented in at least one processor.

The various elements and regions of the drawings have been schematically illustrated. Accordingly, the technical spirit of the disclosure is not limited by relative sizes and distances illustrated in the accompanied drawings.

A glass substrate may be disposed with a thin film transistor (TFT) layer on which a TFT circuit is formed at a front surface thereof, and disposed with a driving circuit for driving the TFT circuit of the TFT layer at a back surface thereof. The glass substrate may be formed in a quadrangle type. Specifically, the glass substrate may be formed in a rectangle type or a square type.

A substrate stacked with the TFT layer (or backplane) on the glass substrate may be referred to as a TFT substrate. The TFT substrate is not limited to a specific structure or type. For example, the TFT substrate referred to in the disclosure may be implemented as an Oxide TFT and a Si TFT (poly silicon, a-silicon), an organic TFT, a graphene TFT, and the like in addition to a Low Temperature Polycrystalline Silicon (LTPS) TFT, and may be applied by making only a P-type (or a N-type) metal oxide semiconductor field effect transistor (MOSFET) in a Si wafer complementary metal oxide semiconductor (CMOS) process.

The front surface of the glass substrate to which the TFT layer is disposed may be divided into an active region and an inactive region. The active region may correspond to a region occupied by the TFT layer at one surface of the glass substrate, and the inactive region may correspond to an edge region in the one surface of the glass substrate. The edge region may include a side surface of the glass substrate. In addition, the edge region may be a region disposed with the TFT circuit at the front surface of the glass substrate and a remaining region excluding the region in which the driving circuit disposed at the back surface thereof is disposed. In addition, the edge region may include the side surface of the glass substrate, and a portion of the front surface of the glass substrate and a portion of the back surface of the glass substrate which are adjacent to the side surface thereof.

The glass substrate may be formed with a plurality of front surface connecting pads which are electrically connected with the TFT circuit through wiring at the edge region of the front surface thereof and a plurality of back surface connecting pads which are electrically connected with the driving circuit through wiring at the edge region of the back surface thereof. The plurality of front surface and back surface connecting pads may be respectively disposed so as to be inserted by a certain distance from the side surface of the glass substrate toward an inner side of the glass substrate. The connecting pads formed at each of the front surface and the back surface of the glass substrate may be electrically connected by side surface wirings formed at the edge region of the glass substrate.

A plurality of pixels may be arranged at the TFT layer of the glass substrate. Each pixel may be formed of a plurality of sub pixels, and one sub pixel may correspond to one micro LED. In the TFT layer, the TFT circuit for driving each pixel may be included. The micro LED may be formed of inorganic emissive materials, and may be a semiconductor chip which is capable of emitting light on its own if power is supplied. In addition, the micro LED may be configured such that anode and cathode electrodes are formed at a same surface, and have a flip chip structure in which an light emissive surface is formed at an opposite side of the electrodes.

A number of pixels mounted to the TFT substrate (including the glass substrate and the TFT layer stacked to the glass substrate) may be determined by a resolution of a display. In addition, in the disclosure, the micro LED may be arranged in pixel units on the TFT substrate. Here, "being arranged in pixel units" may refer to a plurality of pixels with a same pattern being arranged.

The TFT layer stacked and formed on the glass substrate may be configured such that the micro LED is electrically connected. Specifically, the electrode pad of the micro LED may be electrically connected to the electrode pad on the TFT layer, and the electrode of the micro LED and the TFT electrode may have a junction structure in a metallically bonded state.

A display module may form a black matrix between a plurality of micro LEDs arranged on the TFT layer. The black matrix may enhance contract ratio by blocking light form leaking from a periphery of micro LEDs adjacent with one another.

The display module may further include a touch screen panel disposed at a side at which the plurality of micro LEDs emit light, and in this case, a touch screen driver for driving the touch screen panel may be included.

The display module may further include a rear substrate which is disposed at the back surface of the glass substrate and electrically connected through a flexible printed circuit (FPC) for the like, and the display module may further include a communication device capable of receiving data.

The glass substrate mounted with the micro LED and formed with the side surface wirings may be referred to as the display module. The display module as described above may be installed and applied to a wearable device, a portable device, a handheld device, and various electronic products or electronic field devices that require a display as a single unit, and may be applied to a display device such as, for example, and without limitation, a monitor for a personal computer (PC), a high resolution TV, a signage (or, a digital signage), an electronic display, and the like through a plurality of assembly arrangements in a matrix type.

The embodiments of the disclosure will be described in detail below with reference to the accompanied drawing to aid in the understanding of those of ordinary skill in the art.

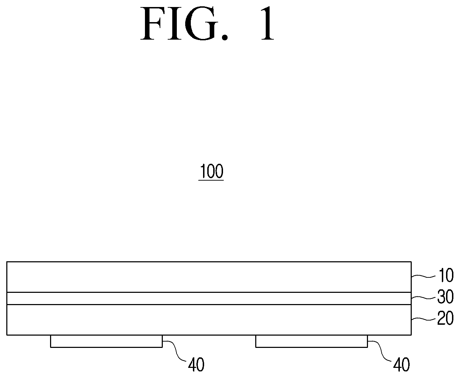

FIG. 1 is a cross-sectional view illustrating a structure of a micro LED chip 100 according to an embodiment of the disclosure.

Referring to FIG. 1, the micro LED chip 100 may be formed of a first semiconductor layer 10 doped with an N-type dopant, a second semiconductor layer 30 disposed at one region of a lower surface of the first semiconductor layer 10 and doped with a P-type dopant, an active layer 20 disposed between the first semiconductor layer 10 and the second semiconductor layer 30 and configured to generate light, and electrode pads 40 disposed at one region of the lower surface of the second semiconductor layer 30.

An atom of a dopant (an impurity) doped at a ground matter which forms each semiconductor layer becomes an N-type semiconductor or a P-type semiconductor by characteristic, the dopant may become the N-type semiconductor in which an electron becomes a carrier due to remaining electron being released after bonding if the atom is higher than the ground matter of the semiconductor, and the dopant may become the P-type semiconductor in which a hole becomes a carrier because the electron is absorbed due to the electron needed for bonding if the atom is lower than the ground matter of the semiconductor. The electron of the first semiconductor layer 10 which is the N-type semiconductor and the hole of the second semiconductor layer 30 which is the P-type semiconductor may meet at the active layer 20 and emit light by emitting an energy corresponding to the band gap in a photon form.

Here, electrode pads 40 disposed at one region of the lower surface of the second semiconductor layer 30 of the micro LED may have a groove structure that deepens as it nears the center part of the electrode pad 40 from the edge region of the electrode pad 40. The groove structure may have a cross-section in a diagonal form connecting an edge of the electrode pad 40 with a center part of the electrode pad 40, a cross-section in a stair form, or a cross-section in an arch form.

However, the arrangement and structure of each configuration that form the micro LED chip 100 is not limited to that described above.

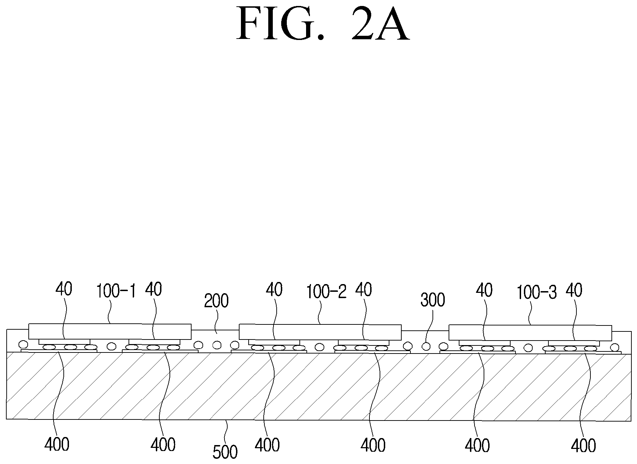

FIG. 2A is a cross-sectional view illustrating a structure of a micro LED panel to which the micro LED chip 100 is disposed at an upper surface thereof according to an embodiment of the disclosure.

Referring to FIG. 2A, the micro LED chip 100 may be disposed at an upper surface of the micro LED panel substrate 500. Specifically, the micro LED chip 100 may be disposed on the panel substrate 500 laminated with an anisotropic conductive film 200 which includes at least one conductive ball 300.

The conductive ball 300 may have a sphere shape having electrical conductivity, and may be formed of an insulating polymer resin and a conductive film that covers the insulating polymer resin, but is not limited thereto.

The electrode 400 on the panel substrate 500 and the electrode pad 40 of the micro LED chip 100 may be disposed to be adjoined, and the conductive ball 300 may be positioned between the electrode 400 and the electrode pad 40 and prevent connection failure of the electrode 400 and the electrode pad 40.

One micro LED chip 100 may be disposed adjoined with two electrodes 400 disposed spaced apart by a pre-set distance on the panel substrate 500. The two electrodes 400 may be + and -, and show different charges. However, the number of electrode 400 that is adjoined with the one micro LED chip 100 and the charges of the electrode 400 are not limited to that described above.

In addition, the micro LED chip 100 may form an RGB sub pixel consisting of a chip 100-1 emitting light of a red color series, a chip 100-2 emitting light of a green color series, and a chip 100-3 emitting light of a blue color series.

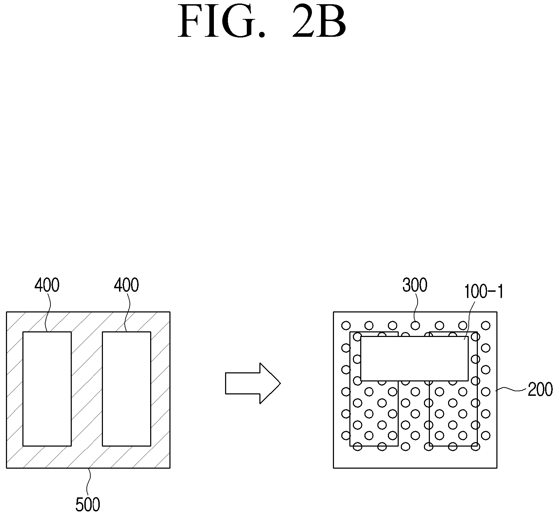

FIG. 2B is a plan view illustrating the electrodes 400, the conductive balls 300, and the anisotropic conductive film (ACF) 200 disposed at an upper surface of the micro LED panel substrate 500 and a structure of the micro LED chip 100 disposed at an upper surface of the anisotropic conductive film 200 according to an embodiment of the disclosure.

Referring to FIG. 2B, at least one electrode 400 may be disposed at the upper surface of the micro LED panel substrate 500.

The upper surface of the panel substrate 500 on which the electrode 400 is provided may be laminated or coated with the anisotropic conductive film 200. At this time, the anisotropic conductive film 200 may include at least one conductive ball 300 inside thereof. The at least one conductive ball 300 may be present in a uniformly distributed and dispersed state inside the anisotropic conductive film 200.

In this state, the micro LED chip 100 may be disposed at the upper surface of the panel substrate 500 laminated with the anisotropic conductive film 200.

The one micro LED chip 100 may be disposed adjoined with two different electrodes 400 disposed spaced apart by a pre-set distance on the panel substrate 500. Specifically, the electrode pad 40 may be formed of a first electrode pad 40 disposed at one region of the lower surface of the second semiconductor layer 30, and a second electrode pad 40 disposed spaced apart by a pre-set distance from the first electrode pad 40 and disposed at one region of the lower surface of the second semiconductor layer 30. Here, the pre-set distance may be less than or equal to 20 µm, but is not limited thereto.

The micro LED panel with the micro LED chip 100 having the structure as described above disposed at the upper surface thereof may be manufactured in a method of thermally compressing the micro LED chip 100 on the panel substrate 500 laminated with the anisotropic conductive film 200, and one problem may arise based therefrom.

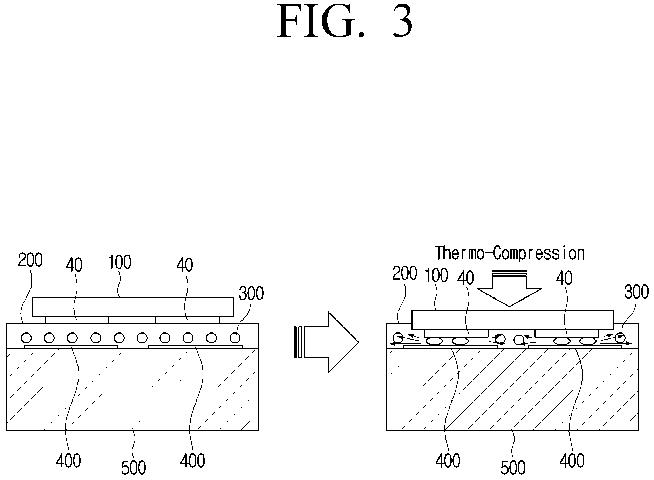

FIG. 3 is a cross-sectional view illustrating a process of thermally compressing the micro LED chip 100 to the upper surface of the micro LED panel substrate 500 according to an embodiment of the disclosure.

Referring to FIG. 3, the micro LED chip 100 may be disposed at the upper surface of the panel substrate 500 laminated with the anisotropic conductive film 200 and manufactured through a thermal compression process.

In this process, the electrode pads 40 disposed at one region of the lower surface of the micro LED chip 100 and the electrodes 400 disposed at the upper surface of the panel substrate 500 may be in contact and the conductive balls 300 positioned therebetween may be pushed out to an outer region which is the periphery due to pressure. If the conductive balls 300 between the electrode pads 40 of the micro LED chip 100 and the electrodes 400 on the panel substrate 500 are pushed outwards due to the pressure, a number of conductive balls 300 between the electrode pads 40 and the electrodes 400 may decrease, and a likelihood of failure occurring due to electrical connection regions of the electrode pads 40 and the electrodes 400 reducing may become higher.

Accordingly, there may be a need to control a flow of conductive balls 300 such that the conductive balls 300 are not pushed from between the electrode pads 40 and the electrodes 400 toward an outer side in the thermal compression process as described above.

The micro LED chip 100 according to an embodiment to achieve the above-described object may be disposed at the lower surface of the second semiconductor layer 30, and improve the connection failure by controlling the flow of conductive balls 300 through a lower surface form of the electrode pad 40 which is disposed adjoined with the electrode 400 on the panel substrate 500.

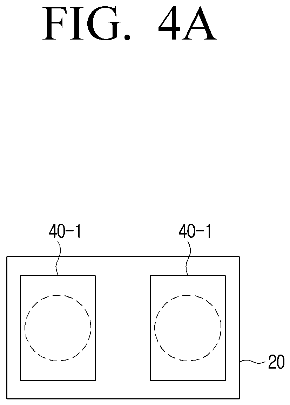

FIG. 4A is a plan view illustrating an example in which a groove structure of an electrode pad of a micro LED chip is a cross section in a diagonal form connecting an edge of the electrode pad 40 and a center part of the electrode pad 40 according to an embodiment of the disclosure.

Referring to FIG. 4A, an electrode pad 40-1 disposed at one region of the lower surface of the second semiconductor layer 30 may be implemented in the groove structure that deepens as it nears a center part of the electrode pad 40-1 from an edge region of the electrode pad 40-1.

The depth of the center part of the groove structure may be variously implemented. The border shape of the edge of the groove structure may be a circle, but may be implemented into various shapes such as, for example, and without limitation, a triangle, a quadrangle, or the like.

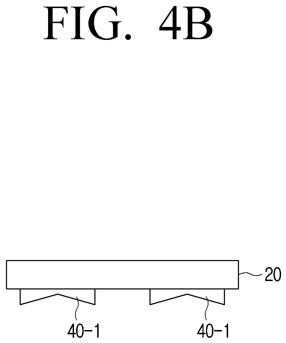

FIG. 4B is a cross-sectional view illustrating an example in which a groove structure of an electrode pad 40-1 of the micro LED chip 100 is a cross section in a diagonal form connecting an edge of the electrode pad 40-1 and a center part of the electrode pad 40-1 according to an embodiment of the disclosure.

Referring to FIG. 4B, the groove structure of the electrode pad 40-1 may have a diagonal form connecting the edge of the electrode pad 40-1 and the center part of the electrode pad 40-1. Here, a slope of a diagonal line may be variously implemented.

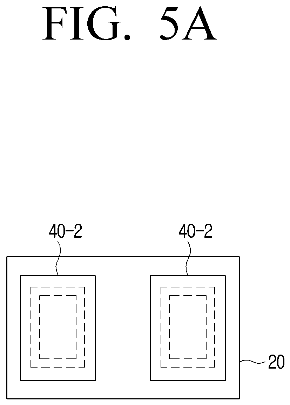

FIG. 5A is a plan view illustrating an example in which a groove structure of an electrode pad 40-2 of the micro LED chip 100 is a cross section in a stair form according to an embodiment of the disclosure.

Referring to FIG. 5A, a groove structure of an electrode pad 40-2 may have a form that deepens as it nears the center part from the edge, but may be formed such that the side end surface of the groove structure is formed in a stair form.

The border shape which is the edge of the groove structure may be a quadrangle, but is not limited thereto, and may be implemented into various shapes such as, a circle, triangle, or the like.

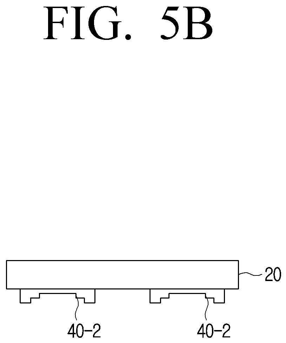

FIG. 5B is a cross-sectional view illustrating an example in which a groove structure of the electrode pad 40-2 of the micro LED chip 100 is a cross-section in a stair form according to an embodiment of the disclosure.

Referring to FIG. 5B, a cross-section of the groove structure of the electrode pad 40-2 may be in the stair form. Here, a number of levels of the stairs may be two to three, but is not limited thereto, and may be formed of various number of levels.

A height of each level in the cross-section in the stair form may be all the same, and an average degree of inclination of the stair form in the cross-section of the stair form may be 45°, but is not limited thereto.

In addition, the inclination of the stair form may be implemented in a form that changes as it nears the center part from the edge of the groove structure of the electrode pad 40-2. For example, the cross-section of the stair form of the groove structure may be implemented in a form in which a height of a level becomes lower as it nears the center part of the groove structure and the height of the level becomes lower as it nears the edge of the groove structure, but is not limited thereto.

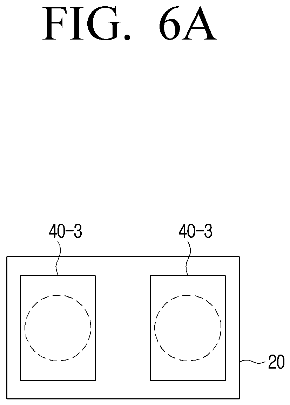

FIG. 6A is a plan view illustrating an example in which a groove structure of an electrode pad 40-3 of the micro LED chip 100 is a cross-section in an arch form according to an embodiment of the disclosure.

Referring to FIG. 6A, the groove structure of the electrode pad 40-3 may have a form that deepens as it nears the center part from the edge, and the side end surface of the groove structure may be formed in the arch form.

The depth of the center part of the groove structure may be variously implemented. The border shape which is the edge of the groove structure may be a circle, but may be implemented to various shapes such as, for example, and without limitation, a triangle, a quadrangle, or the like.

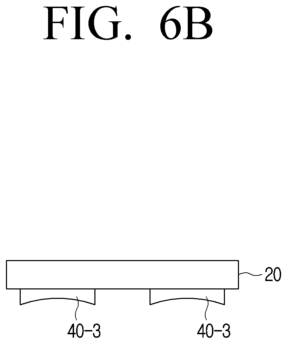

FIG. 6B is a cross-sectional view illustrating an example in which the groove structure of the electrode pad 40-3 of the micro LED chip 100 is a cross-section in an arch form according to an embodiment of the disclosure.

Referring to FIG. 6, a side cross-section of the groove structure may be formed in the arch form. Here, the arch form may be a semicircular form, but is not limited thereto.

The groove structure with the arch shape cross-section may be formed of a surface that is smooth and consistent unlike the groove structure having the stair shape cross-section in which an inside surface of the groove structure is inconsistent and having at least one level.

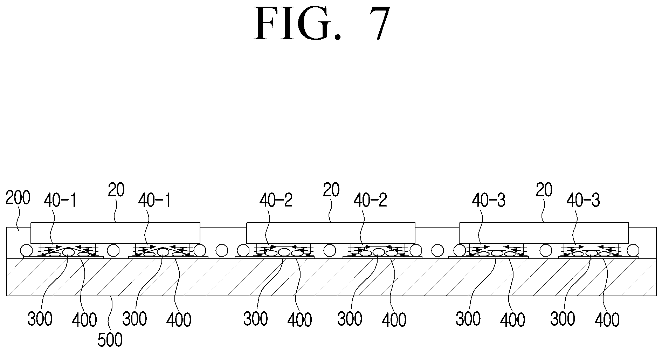

FIG. 7 is a cross-sectional view illustrating a flow of conductive balls 300 attributed to a groove structure of the electrode pad 40 of the micro LED chip 100 according to an embodiment of the disclosure.

Referring to FIG. 7, the electrode pads 40 of the micro LED chip 100 may have a groove structure, and if the groove structure is formed in a form that deepens as it nears the center part of the electrode pads 40 from the edge region of the electrode pads 40, the conductive balls 300 positioned between the electrode pads 40 and the electrodes 400 may be moved to the center part of the electrode pads 40 even if the micro LED chip 100 is compressed on the panel substrate 500 laminated with the anisotropic conductive film 200 in which the conductive balls 300 are uniformly distributed inside thereof. That is, the conductive balls 300 positioned between the electrode pads 40 and the electrodes 400 may not be pushed toward the outer region which is the periphery and move toward an inner side of the groove structure of the electrode pad 40 that is recessed. Therefore, connection failure between the electrode pads 40 and the electrodes 400 may be prevented because the number of conductive balls 300 between the electrode pads 40 and the electrodes 400 can be sufficiently maintained.

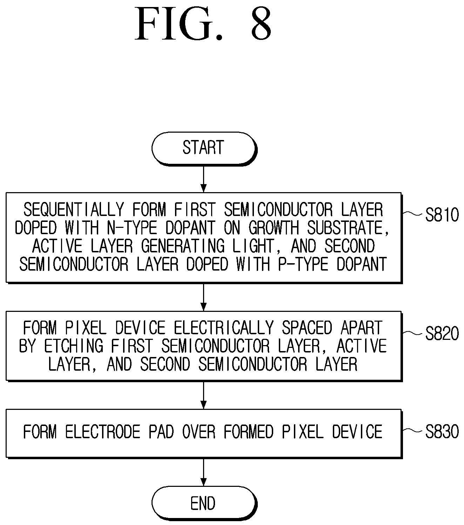

The micro LED chip 100 including the electrode pads 40 with the groove structure as described above and a process of manufacturing a micro LED panel included with the micro LED chip 100 will be described together with FIG. 8 to FIG. 10.

FIG. 8 is a flowchart illustrating a process of manufacturing the micro LED chip 100 according to an embodiment of the disclosure.

Referring to FIG. 8, the first semiconductor layer 10 doped with the N-type dopant, the active layer 20 generating light, and the second semiconductor layer 30 doped with the P-type dopant may be sequentially formed on a growth substrate (S810).

The first semiconductor layer 10 may be formed at one surface of the growth substrate, and the active layer 20 may be formed at an opposite surface of one surface of the first semiconductor layer 10 which is adjoined with the growth substrate may be formed. Then, the second semiconductor layer 30 may be formed at an opposite surface of one surface of the active layer 20 which is adjoined with the first semiconductor layer 10.

The growth substrate may be a mother substrate for growing a first semiconductor layer, and may be formed of, for example, and without limitation, sapphire (Al2O3), silicon carbide (SiC), gallium nitride (GaN), indium gallium nitride (InGaN), aluminum gallium nitride (AlGaN), aluminum nitride (AlN), gallium oxide (Ga2O3), gallium arsenide (GaAs), silicon substrate, or the like.

A pixel device electrically spaced apart by etching the first semiconductor layer 10, the active layer 20, and the second semiconductor layer 30 may be formed (S820).

The micro LED chip 100 may form the RGB sub pixel consisting of the chip 100-1 emitting light of the red color series, the chip 100-2 emitting light of the green color series, and the chip 100-3 emitting light of a blue color series.

Then, the electrode pad 40 may be formed over the formed pixel device (S830). Here, the electrode pad 40 may be formed of the first electrode pad 40 at one region of the lower surface of the second semiconductor layer 30, and the second electrode pad 40 spaced apart by the pre-set distance from the first electrode pad 40 and disposed at one region of the lower surface of the second semiconductor layer 30, and the pre-set distance spaced apart between the first electrode pad 40 and the second electrode pad 40 may be less than or equal to 20 µm. However, the disposition of the first electrode pad 40 and the second electrode pad 40 is not limited thereto.

In addition, the lower surface of the electrode pad 40 may be mechanical molding processed and form the groove structure. Additionally, the lower surface of the electrode pad 40 may be plasma processed or the lower surface of the electrode pad 40 may be etched and form the groove structure, but is not limited to the above.

The electrode pad 40 may be formed for the electrode pad 40 to have a cross-section in a diagonal form connecting the edge of the electrode pad 40 and the center part of the electrode pad 40, a cross-section in a stair form, or a cross-section in an arch-form.

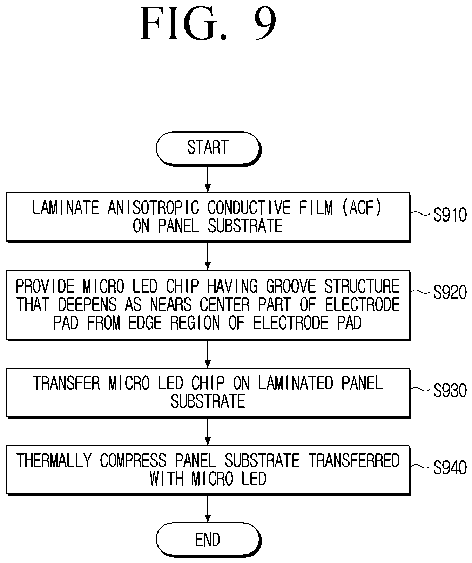

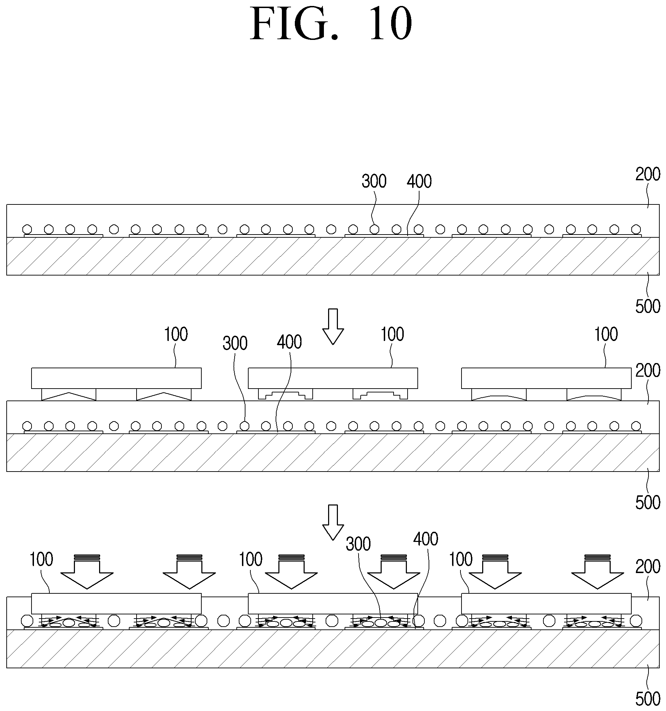

FIG. 9 is a flowchart illustrating a process of manufacturing a micro LED panel according to an embodiment of the disclosure, and FIG. 10 is a cross-sectional view illustrating a process of manufacturing a micro LED panel according to an embodiment of the disclosure.

Referring to FIG. 9, the anisotropic conductive film 200 may be laminated or coated on the panel substrate 500 (S910).

Referring to FIG. 10, at least one electrode 400 may be disposed at the upper surface of the panel substrate 500, and the anisotropic conductive film 200 may be laminated thereover. The anisotropic conductive film 200 laminated over the panel substrate 500 may include conductive balls distributed uniformly therein.

The micro LED chip 100 having the groove structure that deepens as it nears the center part of the electrode pad 40 from the edge region of the electrode pad 40 may be provided (S920). Here, the manufacturing method of the micro LED chip 100 may be as described above together with FIG. 8.

The provided micro LED chip 100 may be transferred on the panel substrate 500 laminated with the anisotropic conductive film 200 (S930).

The panel substrate 500 transferred with the micro LED chip 100 may be thermally compressed (S940). In this process, the conductive balls positioned between the electrode pad 40 and the electrode 400 may move to the center part of the electrode pad 40 and the electrical connection between the electrode pad 40 and the electrode 400 may be improved and thereby, connection failure may be prevented.

In the above, while the disclosure has been illustrated and described with reference to example embodiments of the disclosure, it will be understood that the disclosure is intended to be illustrative, not limiting. It will be understood by those skilled in the art that various changes in form and details may be made therein without departing from the true spirit and full scope of the disclosure, including the appended claims and their equivalents.

## Claims

1. A micro light emitting diode (LED) chip comprising:
a first semiconductor layer doped with an N-type dopant;
a second semiconductor layer provided at a lower surface of the first semiconductor layer, and doped with a P-type dopant;
an active layer provided between the first semiconductor layer and the second semiconductor layer, and configured to emit light; and
an electrode pad provided at a lower surface of the second semiconductor layer,
wherein the electrode pad comprises a groove structure having a depth that increases from an edge of the electrode pad towards a center of the electrode pad.

2. The micro LED chip of claim 1, wherein the groove structure of the electrode pad has a cross-section in a diagonal form connecting the edge of the electrode pad and the center of the electrode pad.

3. The micro LED chip of claim 1, wherein the groove structure of the electrode pad has a cross-section in a stair form.

4. The micro LED chip of claim 1, wherein the groove structure of the electrode pad has a cross-section in an arch form.

5. The micro LED chip of claim 1, wherein the electrode pad comprises:
a first electrode pad provided at a first region of the lower surface of the second semiconductor layer; and
a second electrode pad provided at a second region of the second semiconductor layer and spaced apart from the first electrode pad by a distance that is less than or equal to 20 µm.

6. A method for manufacturing a micro light emitting diode (LED) chip, the method comprising:
sequentially forming a first semiconductor layer doped with an N-type dopant, an active layer configured to emit light, and a second semiconductor layer doped with a P-type dopant on a growth substrate;
forming a pixel device electrically spaced apart by etching the first semiconductor layer, the active layer, and the second semiconductor layer; and
forming an electrode pad over the pixel device,
wherein the electrode pad comprises a groove structure having a depth that increases from an edge of the electrode pad towards a center of the electrode pad.

7. The method of claim 6, wherein the forming the electrode pad comprises forming the groove structure by mechanical molding processing a lower surface of the electrode pad.

8. The method of claim 6, wherein the forming the electrode pad comprises forming the groove structure by plasma processing a lower surface of the electrode pad.

9. The method of claim 6, wherein the forming the electrode pad comprises forming the groove structure by etching a lower surface of the electrode pad.

10. The method of claim 6, wherein the forming the electrode pad comprises forming the electrode pad to have a cross-section in at least one of a diagonal form connecting the edge of the electrode pad and the center of the electrode pad, a cross-section in a stair form, or a cross-section in an arch-form.

11. The method of claim 6, wherein the forming the electrode pad comprises:
forming a first electrode pad provided at a first region of a lower surface of the second semiconductor layer and a second electrode pad provided at a second region of the second semiconductor layer and spaced apart from the first electrode pad by a distance that is less than or equal to 20 µm.
